# EUROPEAN PATENT APPLICATION

(11) **EP 1 316 973 A1**
(43) Date of publication of application: **04.06.2003**
(21) Application number: 01941079.4
(22) Date of filing: 18.06.2001
(51) Int. Cl.: H01B 12/06, H01B 13/00

(54) **OXIDE SUPERCONDUCTING ELECTROCONDUCTIVE ARTICLE AND METHOD FOR ITS PREPARATION**

(30) Priority: 15.08.2000 JP 2000246454
(71) Applicant: International Superconductivity technology Center, The Juridical Foundation, Tokyo 105-0004 (JP)
(72) Inventor: KAKIMOTO, Kazuomi, Int. Superconduct. Tech. Ctr, Tokyo 135-0062 (JP); IZUMI, Toru, Int. Superconduct. Tech. Ctr, Tokyo 135-0062 (JP); HOBARA, Natsuro, Int. Superconduct. Tech. Ctr, Tokyo 135-0062 (JP); NAKAMURA, Yuichi, Int. Superconduct. Tech. Ctr, Tokyo 135-0062 (JP); IZUMI, Teruo, Int. Superconduct. Tech. Ctr, Tokyo 135-0062 (JP); SHIOHARA, Yuh, Int. Superconduct. Tech. Ctr, Tokyo 135-0062 (JP)
(74) Representative: Ilgart, Jean-Christophe
(86) International application number: JP0105169
(87) International publication number: WO02015204

(57) **Abstract**

The present invention provides an oxide superconducting conductor A comprising an oxide buffer layer 2 on a base material 1 composed of a high melting point metal, a solid solution layer 4 having a structure similar to an oxide superconducting substance containing constituent elements of the oxide buffer layer 2 on the oxide buffer layer 2, and an oxide superconducting layer having a peritectic temperature lower than that of the solid solution layer 4 having a structure similar to an oxide superconducting substance on the solid solution layer 4 having a structure similar to an oxide superconducting substance.

## Description

### Technical Field

The present invention relates to an oxide superconducting conductor that can be used in a superconducting cable, superconducting magnet or current lead and so forth, and to its production method. In particular, the present invention relates to that which forms an oxide superconducting layer on an oxide buffer layer on a base material using liquid phase epitaxy, and its production method.

### Background Art

Oxide superconducting conductors have electrical anisotropy in which electricity flows easily in a specific direction of its crystal axis, but flows with difficulty in other specific directions, and because of this electrical anisotropy, in the case of composing an oxide superconducting conductor using an oxide superconductor, has the problem of requiring that the crystals of the oxide superconductor being oriented in the specific direction in which electricity flows.

In addition, oxide superconductors are a type of ceramic, and since they are susceptible to bending and strain, in the case of using an oxide superconductor as the oxide superconductor of superconducting wire and so forth, a thin film oxide superconducting layer is provided on a flexible, tape-like metal base material.

In consideration of these background circumstances, as an example of a means for depositing an oxide superconducting layer on a metal tape-like base material in the prior art. Although methods have been deployed in which an oxide superconducting layer is deposited on a tape-like base material by chemical vapor deposition (CVD) or other vapor phase method, although deposition by vapor phase methods serve as a means of being able to produce an oxide superconducting layer having superior crystal orientation, since the deposition rate is extremely poor, they have the problem of not being effective for producing thick film superconducting layers or long superconducting layers.

In consideration of this background, in recent years, liquid phase epitaxy has been proposed as an example of a method for being able to obtain high-speed deposition of thick films of oxide superconducting layers.

This liquid phase epitaxy comprises of attempting to form an oxide superconducting layer on the surface portion of a base material extracted from the liquid surface of a molten liquid by using a molten liquid having a composition that approximates the composition of the target oxide superconductor, immersing a base material in that molten liquid and gradually lifting out the base material from the molten liquid. According to this liquid phase epitaxy, superconducting layers several tens of times thicker than the thin films obtained with vapor phase methods can be formed at a rapid deposition rate.

In order to form an oxide superconducting layer on a base material tape by this liquid phase epitaxy, the inventors of the present invention conducted an experiment on a method in which NiO is formed as a buffer layer on an alloy tape base material, NiO is melted in a molten liquid containing the constituent elements of an oxide superconductor, the previous alloy tape with the buffer layer is immersed in this molten liquid and then removed, a solid solution layer having a structure similar to the oxide superconducting substance containing NiO is formed on this buffer layer, and then an oxide superconducting layer is separately formed by liquid phase epitaxy on a solid solution layer having a structure similar to this oxide superconducting substance.

However, according to this method, in the case a Y- or Sm-based oxide superconductor is attempted to be produced by adding NiO to the molten liquid, there was the problem of a large decrease in the peritectic temperature making it difficult to deposit the same type of oxide superconducting layer following deposition of a superconducting solid solution layer. In addition, in this method, since the crystallization temperature of the Ba-Cu-Ni-O compound rises, in the producing of a Y-based oxide superconductor, there was the problem of the small difference between the crystallization temperature and peritectic temperature of the Ba-Cu-Ni-O compound typically making it difficult to deposit a solid solution layer having a structure similar to the oxide superconducting substance of the target composition.

### Disclosure of the Invention

On the basis of the background, one object of the present invention is to provide an oxide superconducting conductor that attempts to exhibit a high critical current by inhibiting crystallization of unnecessary compounds and form an oxide superconducting layer of a target composition even in the case of using technology in which constituent elements of an oxide buffer layer are added to a molten liquid.

The other object of the present invention is to provide a production method capable of forming a thick film oxide superconducting layer on a base material at a deposition rate that is considerably greater than vapor phase methods. In addition, the other object of the present invention is to provide a production method in which an oxide superconducting conductor is produced by forming a solid solution layer so as not to damage an oxide buffer layer by molten liquid, and further form an oxide superconducting layer so as to not damage the solid solution layer, in the case of forming a oxide superconducting material layer by liquid phase epitaxy by immersing a base material provided with an oxide buffer layer in a molten liquid.

The present invention achieves the object by providing an oxide superconducting conductor comprising: an oxide buffer layer on a base material made of a high melting point metal; a solid solution layer having a structure similar to an oxide superconducting substance containing constituent elements of the oxide buffer layer on the oxide buffer layer; and an oxide superconducting layer having a peritectic temperature lower than that of the solid solution layer on the solid solution layer having a structure similar to an oxide superconducting substance.

In this oxide superconducting conductor of the present invention, since an oxide buffer layer is formed on a base material, in the case of forming a solid solution layer having a structure similar to an oxide superconducting substance formed thereon by liquid phase epitaxy, by adding a constituent element of the oxide buffer layer to the molten liquid, liquid phase epitaxy can be carried out while reducing the risk of damaging the oxide buffer layer with molten liquid, and a solid solution layer can be formed on the oxide buffer layer that has a structure similar to an oxide superconducting substance of a desired composition.

In addition, the present invention achieves the object by providing an oxide superconducting conductor comprising: an oxide buffer layer composed of NiO on a base material made of a high melting point metal; a solid solution layer having a structure similar to an oxide superconducting substance containing NiO on the oxide buffer layer; and an oxide superconducting layer having a peritectic temperature lower than that of the solid solution layer on the solid solution layer having a structure similar to an oxide superconducting substance.

In addition, the present invention achieves the object by providing an oxide superconducting conductor comprising: an oxide buffer layer composed of MgO on a base material made of a high melting point metal; a solid solution layer having a structure similar to an oxide superconducting substance containing constituent elements of the oxide buffer layer on the oxide buffer layer; and an oxide superconducting layer having a peritectic temperature lower than that of the solid solution layer on the solid solution layer having a structure similar to an oxide superconducting substance.

In addition, the present invention achieves the object by providing an oxide superconducting conductor comprising: an oxide buffer layer on a base material made of a high melting point metal; an Nd-based solid solution layer having a structure similar to an oxide superconducting substance containing constituent elements of the oxide buffer layer on the oxide buffer layer; and an oxide superconducting layer composed of a Sm-, Gd-, Dy-, Y- or Yb-based oxide superconductor having a peritectic temperature lower than that of an Nd-based oxide superconductor that composes the Nd-based solid solution layer on the Nd-based solid solution layer having a structure similar to an oxide superconducting substance.

In addition, the present invention achieves the object by providing an oxide superconducting conductor comprising: an oxide buffer layer composed of NiO on a base material made of a high melting point metal; an Nd-based solid solution layer having a structure similar to an oxide superconducting substance containing NiO on the oxide buffer layer; and an oxide superconducting layer composed of a Sm-, Gd-, Dy-, Y- or Yb-based oxide superconductor having a peritectic temperature lower than that of an Nd-based oxide superconductor that composes the Nd-based solid solution layer on the Nd-based solid solution layer having a structure similar to an oxide superconducting substance.

In addition, the present invention achieves the object by providing an oxide superconducting conductor comprising: an oxide buffer layer composed of NiO on a base material made of a Ni-based alloy; an Nd-based solid solution layer having a structure similar to an oxide superconducting substance containing NiO on the oxide buffer layer; and an oxide superconducting layer composed of a Y-based oxide superconductor having a peritectic temperature lower than that of an Nd-based oxide superconductor that composes the Nd-based solid solution layer on the Nd-based solid solution layer having a structure similar to an oxide superconducting substance.

In addition, the present invention achieves the object by providing an oxide superconducting conductor comprising: an oxide buffer layer on a base material made of a high melting point metal; a Sm-based solid solution layer having a structure similar to an oxide superconducting substance containing constituent elements of the oxide buffer layer on the oxide buffer layer; and an oxide superconductor layer composed of a Gd-, Dy-, Y-or Yb-based oxide superconductor having a peritectic temperature lower than that of a Sm-based oxide superconductor that composes the sSm-based olid solution layer on the Sm-based solid solution layer having a structure similar to an oxide superconducting substance.

In addition, the present invention achieves the object by providing an oxide superconducting conductor comprising: an oxide buffer layer composed of NiO on a base material made of a high melting point metal; a Sm-based solid solution layer having a structure similar to an oxide superconducting substance containing NiO on the oxide buffer layer; and an oxide superconducting layer composed of a Gd-, Dy-, Y- or Yb-based oxide superconductor having a peritectic temperature lower than that of a Sm-based oxide superconductor that composes the Sm-based solid solution layer on the Sm-based solid solution layer having a structure similar to an oxide superconducting substance.

Furthermore, the present invention achieves the object by providing an oxide superconducting conductor comprising: an oxide buffer layer composed of NiO on a base material made of a Ni-based alloy; a Sm-based solid solution layer having a structure similar to an oxide superconducting substance containing NiO on the oxide buffer layer; and an oxide superconducting layer composed of a Y-based oxide superconductor having a peritectic temperature lower than that of a Sm-based oxide superconductor that composes the Sm-based solid solution layer on the Sm-based solution layer having a structure similar to an oxide superconducting substance.

In the oxide superconducting conductor of the present invention, the solid solution layer having a structure similar to an oxide superconducting substance is preferably formed by liquid phase epitaxy in which a base material is immersed in a molten liquid, and the oxide superconducting layer is preferably formed by liquid phase epitaxy in which a base material is immersed in a molten liquid.

The oxide superconducting conductor of the present invention comprises a base material, an oxide buffer layer, a solid solution layer having a structure similar to an oxide superconducting substance, and an oxide superconducting layer, and an oxide superconducting layer having a peritectic temperature lower than that of the solid solution layer having a structure similar to the oxide superconducting substance is formed on the solid solution layer having a structure similar to the oxide superconducting substance. Therefore, there is no melting of the solid solution layer having a structure similar to the oxide superconducting substance during formation of an oxide superconducting layer, thereby enabling the formation of an oxide superconducting layer in a stable state without precipitation of an unnecessary compound phase.

In addition, if a base material in which the surface orientation has been controlled is used for the base material, a solid solution layer can be generated that has a structure similar to the oxide superconducting substance in a state that matches the crystal orientation of the base material, and moreover an oxide superconducting layer can be generated in the state in which the crystals have been oriented so as to match the solid solution layer having a structure similar to the oxide superconducting substance. Therefore, an oxide superconducting conductor can be obtained that is provided with an oxide superconducting layer having superior critical current characteristics.

In addition, if an oxide buffer layer in which surface orientation has already been controlled is used for the oxide buffer layer, a solid solution layer can be generated that has a structure similar to an oxide superconducting substance in a state that matches the crystal orientation of the oxide buffer layer, and moreover, an oxide superconducting layer can be generated in a state in which the crystals have been oriented so as to match the solid solution layer having a structure similar to the oxide superconducting substance. Therefore, an oxide superconducting conductor can be obtained that is provided with an oxide superconducting layer having superior critical current characteristics.

Moreover, since an oxide superconducting layer is obtained in a state that is thicker than an oxide superconducting layer obtained by conventional vapor phase methods, a superior oxide superconducting conductor can be obtained that exhibits a higher critical current than an oxide superconducting conductor having an oxide superconducting layer obtained by conventional vapor phase methods.

In addition, since the constituent elements of the oxide buffer layer are contained in the solid solution layer having a structure similar to an oxide superconducting substance, in the case of forming the solid solution layer by liquid phase epitaxy, a molten liquid can be used that contains constituent elements of the oxide buffer layer in the molten liquid. In the case of using this molten liquid and immersing a base material provided with an oxide buffer layer in this molten liquid, a solid solution layer can be formed having a structure similar to the oxide superconducting substance without causing elution of the constituent elements of the oxide buffer layer into the molten liquid. Accordingly, in the case of generating a solid solution layer having a structure similar to an oxide superconducting substance by liquid phase epitaxy, a solid solution layer can be generated that has a structure similar to an oxide superconducting substance without allowing the base material to be damaged by molten liquid.

Moreover, since a solid solution layer having a structure similar to an oxide superconducting substance can be generated on a base material in an undamaged state, a thick film oxide superconducting layer having a high critical current can be obtained by liquid phase epitaxy based on this solid solution layer having a structure similar to an oxide superconducting substance.

A base material formed from a Ni-based alloy or a base material formed from MgO may be used for the base material.

As a result of forming the base material from a high melting point metal such as Ni, a base material can be obtained having reliable heat resistance and corrosion resistance. In addition, as a result of composing the oxide buffer layer from an oxide of MgO or NiO, even in the case of producing by liquid phase epitaxy by immersing in a molten liquid and heating to a high temperature, the reaction with the base material can be inhibited, and resistance to the molten liquid in the case of carrying out liquid phase epitaxy can be made to be reliable.

In addition, the present invention achieves the object by providing a production method of the oxide superconducting conductor comprising the steps of: dissolving metal elements that compose an oxide buffer layer in a molten liquid of elements that compose a solid solution layer; immersing a base material provided with an oxide buffer layer in the obtained molten liquid and removing the base material provided with an oxide buffer layer from the obtained molten liquid, and thereby forming a solid solution layer having a structure similar to an oxide superconducting substance on the oxide buffer layer while preventing dissolution of the oxide buffer layer itself; and then forming an oxide superconducting layer on the solid solution layer having a structure similar to an oxide superconducting substance.

In the production method of the oxide superconducting conductor of the present invention, since the oxide buffer layer is formed on a base material, in the case of forming the solid solution layer having a structure similar to an oxide superconducting substance by liquid phase epitaxy, by adding constituent elements of the oxide buffer layer to the molten liquid, liquid phase epitaxy can be carried out without allowing the molten liquid to damage the oxide buffer layer, and the solid solution layer can be formed that has a structure similar to the target oxide superconducting substance on the oxide buffer layer.

In the production method of the present invention, when forming the oxide superconducting layer on the solid solution layer having a structure similar to an oxide superconducting substance, a liquid phase epitaxy is carried out in which the base material provided with the solid solution layer having a structure similar to an oxide superconducting substance is immersed in a molten liquid that does not contain metal elements that compose the oxide buffer layer but contains elements that compose the oxide superconducting layer, while preventing dissolution of the solid solution layer having a structure similar to an oxide superconducting substance.

In the case of forming the oxide superconducting layer by liquid phase epitaxy, since the oxide superconducting layer is generated with a molten liquid that does not contain metal elements of the oxide buffer layer, the oxide superconducting layer of the target composition can be obtained by inhibiting the precipitation of unnecessary compounds.

In the production method of the present invention, a base material made of a Ni-based alloy may be used for the base material, and an oxide buffer layer made of Ni oxide may be used for the oxide buffer layer.

### Brief Description of the Drawings

FIG. 1 is a cross-sectional view showing a first embodiment of an oxide superconducting conductor according to the present invention.
FIG. 2 is a drawing showing the results of thermal analysis of a Y123 + NiO sample.
FIG 3 is a drawing showing the dependency on the amount of NiO added of the peritectic temperature of a Y123 + NiO sample.
FIG. 4 is a drawing showing the results of thermal analysis showing the peritectic temperature of BaCuO_{y}.
FIG. 5 is a drawing showing the results of thermal analysis showing the peritectic temperature of Ba-Cu-Ni-O.
FIG. 6 is a drawing showing the Y123 precipitation temperature margin obtained from a mixed powder molten liquid of Y123 powder, BaCu powder and NiO powder.
FIG. 7 is a showing drawing the Nd123 precipitation temperature margin obtained from a mixed powder molten liquid of Nd123 powder, BaCu powder and NiO powder.

### Modes for Carrying Out the Invention

Although the following provides an explanation of modes for carrying out the invention with reference to the drawings, the present invention is not limited to the following modes for carrying out the invention.

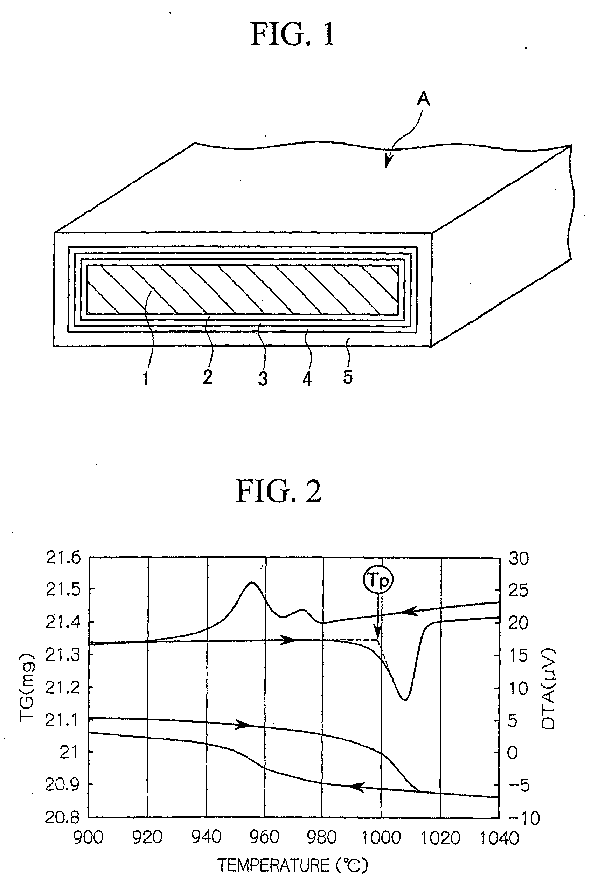

FIG. 1 shows a first embodiment of an oxide superconducting conductor according to the present invention. Oxide superconducting conductor A of this embodiment comprises a base material tape 1, an oxide buffer layer 2 that respectively and sequentially covers the peripheral surface of this base material 1, an oxide superconducting seed layer 3 that covers the oxide buffer layer 2, a solid solution layer 4 having a structure similar to an oxide superconducting substance that covers the oxide superconducting seed layer 3, and an oxide superconducting layer 5 that covers the solid solution layer 4 having a structure similar to an oxide superconducting substance.

Furthermore, although a structure is shown in FIG. 1 in which the oxide buffer layer 2, the oxide superconducting seed layer 3, the solid solution layer 4 having a structure similar to an oxide superconducting substance, and the oxide superconducting layer 5 cover the entire peripheral surface of the base material 1, a structure may naturally also be employed in which the oxide buffer layer 2, the oxide superconducting seed layer 3, the solid solution layer 4 having a structure similar to an oxide superconducting substance, and the oxide superconducting layer 5 are laminated over only the upper surface, only the lower surface of only both the upper and lower surfaces of the base material 1.

The base material 1 is made of a high melting point metal having a melting point of about 1,000 to 2,000°C and superior heat resistance, examples of which include a Ni-based alloy such as HASTELLOY ®, NiCr-based alloy, Ni and Zr. Furthermore, a plate-shaped base material may naturally also be used for the base material 1 instead of the tape-shaped base material shown in the drawing. In this case, an oriented Ni alloy substrate, MgO, SrTiO₃ or other substrate having superior crystal orientation may also be used. The use of these base materials 1 having superior orientation is preferable since it allows the orientation of other layers laminated thereon to be easily controlled.

HASTELLOY® is known to be a NiCr-based alloy having superior heat resistance and oxidation resistance, and is a composite Ni alloy comprising the addition of required amounts of additive elements such as Mn, Fe, Co, Cr, Si, Fe and W to Ni. Specific known examples of which include HASTELLOY A ® having a composition containing 20% (% by weight, hereinafter to indicate the same) of Mo, 2.0% of Mn, 20% of Fe, and the balance being Ni and unavoidable impurities; HASTELLOY B ® having a composition containing 26 to 30% of Mo, 2.5% of Co, 1.0% each of Cr, Mn and Si, 4 to 7% of Fe, and the balance being Ni and unavoidable impurities; and HASTELLOY C ® having a composition containing 15 to 17% of Mo, 14.5 to 16.5% of Cr, 3 to 4.5% of W, 1.0% each of Mn and Si, 4 to 7% of Fe, and the balance being Ni and unavoidable impurities, and of which any may be used. A flexible base material in the form of a tape having a thickness of about 0.1 to 0.5 mm can be used for the base material 1 used in this embodiment.

The oxide buffer layer 2 is preferably composed of a material having low reactivity such as a Ni-based alloy ,for example, HASTELLOY ® that composes the base material 1 or Zr. A specific example of which is a material composed of NiO. In addition, oxide buffer layer 2 may also be composed of MgO.

This oxide buffer layer 2 is used for the purpose of preventing dissolution of the base material 1 in the case HASTELLOY ® that composes the base material 1 is immersed in a molten liquid of an oxide superconductor to be described later. Therefore, the oxide buffer layer 2 preferably has a crystal structure that approximates the oxide superconductor that is used, has a lattice constant that facilitates the epitaxial growth of crystals in the case of growing crystals of an oxide superconductor, and is able to serve as a substrate film for deposition of an oxide superconductor. The thickness of the oxide buffer layer 2 is preferably 0.5 x 10⁻⁶ m (0.5 µm) to 2 x 10⁻⁶ m (2 µm), and more specifically, may have a film thickness of about 1 x 10⁻⁶ m (1 µm).

The oxide superconducting seed layer 3 should be a layer made of an oxide superconductor represented with the composition formula REₐBa_{b}Cu₃O_{y} (wherein RE represents one or two or more elements selected from Y and the rare earth elements Nd, Sm, Dy, Gd, Yb, Ho, Er and Tm). In addition, the oxide superconducting seed layer 3 may be a layer having a composition that is the same or different from the solid solution layer 4 having a structure similar to an oxide superconducting substance formed later. This oxide superconducting seed layer 3 is preferably formed by a vapor phase method such as laser deposition, CVD or sputtering, has superior crystal orientation, and its thickness is about 0.01 x 10⁻⁶ m (0.01 µm) to 1 x 10⁻⁶ m (1 µm).

The solid solution layer 4 having a structure similar to an oxide superconducting substance differs from the target oxide superconducting layer 5 for conducting current. The solid solution layer 4 is required to be composed of an oxide superconductor having a higher peritectic temperature than that of the oxide superconducting layer 5, and requires the use of that to which metal elements that compose the oxide buffer layer 2 are added and put into solid solution. For example, in the case the oxide superconductor is represented with the composition formula REₐBa_{b}Cu₃O_{y} (wherein RE represents one or two or more elements selected from Y, Nd, Sm, Dy, Gd and Yb), it was determined from experiments conducted by the inventors of the present invention that the relationship of the peritectic temperatures of an oxide superconductor is such that Nd (approx. 1080°C) > Sm (approx. 1050°C) > Gd (approx. 1020°C) > Dy (approx. 1010°C) > Y (approx. 1004°C) > Yb (approx. 1000°C). Therefore, metal elements are suitably selected and used from among these. Furthermore, the standards by which oxide superconductors are selected from among these are described in the case of the explanation of oxide superconducting layer 5 to be later described in detail.

Among these, Nd-based oxide superconductors represented with the composition formula Nd₁+ₓBa₂₋ₓCu₃O_{y} or Sm-based oxide superconductors represented with the compositional formula Sm₁Ba₂Cu₃O_{y} are useful.

The solid solution layer 4 having a structure similar to an oxide superconducting substance contains elements that compose the oxide buffer layer 2 and the constituent elements of the oxide superconductor having the previously indicated composition, which are in the solid solution state. A specific example of an element added to the solid solution layer 4 having a structure similar to an oxide superconducting substance is NiO. The NiO can be added with reference to the solid solution limiting amount.

This solid solution layer 4 having a structure similar to an oxide superconducting substance is in the form of a thin film or thick film formed by liquid phase epitaxy from a molten liquid that contains both the constituent elements of the oxide superconductor and the constituent elements of the oxide buffer layer 2. This solid solution layer 4 having a structure similar to an oxide superconducting substance has a thickness within the range of 0.5 x 10⁻⁶ m (0.5 µm) to 3 x 10⁻⁶ m (3 µm), and, for example, has a thickness of about 1 x 10⁻⁶ m (1 µm).

Since this solid solution layer 4 having a structure similar to an oxide superconducting substance contains the solid solution limiting amount of the constituent elements that compose the oxide buffer layer 2, the solid solution layer 4 is inferior to oxide superconducting layer 5 to be described later in terms of superconductivity. However, it is effective as a base layer for growing oxide superconducting layer 5 by liquid phase epitaxy. Therefore, a thin layer of the layer is adequate, and in the case of being in the form of a thin film, the speed at the time of formation by liquid phase epitaxy can be increased.

The oxide superconducting layer 5 is composed of an oxide superconductor of a different type than the constituent materials of the solid solution layer 4 having a structure similar to an oxide superconducting substance. The oxide superconductor layer 5 is formed into the form of a thick film by liquid phase epitaxy to be described later. , and this oxide superconducting layer 5 is the main superconducting layer for conducting electrical current. Although this oxide superconducting layer 5 may have a thickness within the range of 1 x 10⁻⁶ m (1 µm) to 10 x 10⁻⁶ m (10 µm), its thickness is not limited to this range.

Among the previously mentioned composition systems as well, Y-based oxide superconductors represented with the compositional formula Y₁Ba₂Cu₃O_{y} and Sm-based oxide superconductors represented with the compositional formula Sm₁Ba₂Cu₃O_{y} are widely used and useful.

The composition systems that can be selected as combinations of the oxide superconducting layer 5 and the solid solution layer 4 having a structure similar to an oxide superconducting substance are selected according to the magnitude of the previously described peritectic temperatures.

A molten liquid in which the required additives have been dissolved is used in the liquid phase epitaxy used in producing these layers. Therefore, a peritectic reaction is used in the case of growing oxide superconducting layer 5 on the surface of the solid solution layer 4 having a structure similar to an oxide superconducting substance by immersing and then removing base material 1 provided with the oxide buffer layer 2 and the solid solution layer 4 having a structure similar to an oxide superconducting substance have been formed, from a molten liquid for generation of oxide superconducting layer 5. A detailed explanation of which is provided to follow.

In producing oxide superconducting conductor A having the structure shown in FIG. 1, a base is first formed by forming oxide buffer layer 2 on the peripheral surface of base material 1, and forming oxide superconducting seed layer 3 on oxide buffer layer 2.

The oxide buffer layer 2 is formed on the peripheral surface of the base material 1 by a vapor phase method such as laser deposition. This oxide buffer layer 2 is not required to be thicker than the oxide superconducting layer 5 to be formed later. Since, the oxide buffer layer 2 is provided for the purpose of aligning the crystal orientation of the oxide superconducting seed layer 3 to be formed later, it should be formed to a thickness of about 0.5 x 10⁻⁶ m (µm) to 2 x 10⁻⁶ m (µm). Accordingly, the oxide buffer layer 2 can be formed to a thickness of about 1 x 10⁻⁶ m (1 µm) by a vapor phase method (vapor phase method such as CVD, sputtering or laser deposition).

Then, the oxide superconducting seed layer 3 is formed on the peripheral surface of the oxide buffer layer 2 by a vapor phase method such as laser deposition, CVD or sputtering. Since this oxide superconducting seed layer 3 is to serve as a seed for growth in the case of growing a thick film of the solid solution layer having a structure similar to an oxide superconducting substance from a molten liquid by liquid phase epitaxy to be explained later, it is not required to be formed thickly. The oxide superconducting seed layer 3 should be formed to a thickness of about 0.01 x 10⁻⁶ m (0.01 µm) to 1 x 10⁻⁶ m (1 µm), and for example, 1 x 10⁻⁶ m (µm), which is a thickness that allows it to be formed easily by a liquid phase method. Accordingly, the oxide superconducting seed layer 3 can be formed comparatively easily on a long base even by a vapor phase method.

Next, in order to form the solid solution layer 4 having a structure similar to an oxide superconducting substance, a molten liquid is prepared in which constituent metal elements of the oxide buffer layer 2 are dissolved in a molten liquid of the constituent elements of the solid solution layer 4 having a structure similar to an oxide superconducting substance. Here, a solid solution layer, in which NiO that composes the oxide buffer layer 2 is dissolved in a molten liquid of an Nd-based or Sm-based oxide superconductor having a high peritectic temperature, can preferably be used for the solid solution layer 4 having a structure similar to an oxide superconducting substance.

In order to form the solid solution layer 4 having a structure similar to an oxide superconducting substance on the oxide superconducting seed layer 3, a liquid phase epitaxy method is used in which a base provided with the oxide buffer layer 2 and the oxide superconducting seed layer 3 is immersed in and then removed from a molten liquid of an oxide superconductor.

In performing liquid phase epitaxy, a procedure is carried out in which, for example, a molten liquid in which a saturating amount of an oxide buffer layer constituent element such as NiO has been added relative to the molten liquid of the oxide superconductor that composes the solid solution layer 4 having a structure similar to an oxide superconducting substance is filled into a container, the base is immersed in this liquid and then gradually taken out.

As a result of the procedure, components of the molten liquid adhere to the surface of the base that passes through the molten liquid, and crystals of the solid solution layer 4 having a structure similar to an oxide superconducting substance can be grown in a satisfactory crystal orientation state on the surface of the base by using the oxide superconducting seed layer 3 as a seed crystal.

Furthermore, the film thickness of the solid solution layer 4 having a structure similar to an oxide superconducting substance is thinner than the oxide superconducting layer 5 to be formed later, and may be a thin film equivalent to the oxide buffer layer 2 and the oxide superconducting seed layer 3. The reason for adding NiO to this solid solution layer 4 having a structure similar to an oxide superconducting substance is to prevent the oxide buffer layer 2 from reacting with the molten liquid heated to a high temperature when the base is immersed in this molten liquid since this molten liquid is at a high temperature of greater than 1,000°C, and to prevent elution of the oxide buffer layer 2 into the molten liquid if this reaction should happen to occur to a certain extent.

If a large amount of NiO is added to the molten liquid beyond the saturating amount, there is little risk of the NiO of the oxide buffer layer 2 eluting out even if the NiO oxide buffer layer 2 reacts with the molten liquid, and there is no damage to oxide buffer layer 2.

Next, in order to form the oxide superconducting layer 5 on the solid solution layer 4 having a structure similar to an oxide superconducting substance, a second round of liquid phase epitaxy is carried out in which the base provided with the oxide buffer layer 2, the oxide superconducting seed layer 3 and the solid solution layer 4 having a structure similar to an oxide superconducting substance is immersed in a molten liquid of an oxide superconductor and then taken out.

In performing this second round of liquid phase epitaxy, a procedure is carried out in which, for example, a molten liquid of a composition approximating an oxide superconductor is filled into a container, the base provided with the solid solution layer 4 having a structure similar to an oxide superconducting substance is immersed in the molten liquid and then gradually taken out. A molten liquid to which metal elements of the oxide buffer layer 2 have not been added is used for the molten liquid for the second round of liquid phase epitaxy used here.

In the case of employing a structure that uses the oxide superconducting layer 5 having a compositional system represented with Y₁Ba₂Cu₃O_{y}, an example of the molten liquid that can be used for forming the oxide superconducting layer 5 is a molten liquid obtained by containing a powder having a composition of Y₂Ba₁Cu₁O₅ (abbreviated as Y211) in the bottom of a container, placing a mixture having a composition of 3 BaCuO₂ + 2 CuO on this powder, and then melting the entire composition at the ratio of, for example, Y:Ba:Cu = 6:36:58.

In addition, in the case of employing a structure that uses the oxide superconducting layer 5 having a compositional system represented with Nd₁Ba₂Cu₃O_{y}, the oxide superconducting layer 5 is formed by containing a molten liquid of the composition represented with Nd₄Ba₂Cu₂O_{y} in the bottom of a container, and controlling the temperatures of the molten liquid in the upper portion of the container and the molten liquid in the bottom of the container so as so contain a molten liquid of a composition represented with NiO + Ba₃Cu₄O_{y} in the upper portion of the container. In the case of using, for example, an Nd-based molten liquid, the upper portion of the container is heated to 1,057°C, and the bottom of the container is heated to about 1,080°C.

As a result of the procedure, components of the molten liquid adhere to the surface of the base that is lifted out from the upper portion of the molten liquid, and crystals of an oxide superconducting material layer having a compositional system represented with Y₁Ba₂Cu₃O_{y} can be grown in a satisfactory crystal orientation state on the surface of the base by using solid solution layer 4 having a structure similar to an oxide superconducting substance as a seed crystal. This is because, since the bottom of the molten liquid is made to be a high-temperature region, while the upper portion of the molten liquid is made to be a low-temperature region, convection occurs from the bottom to the upper portion of the molten liquid, and when molten liquid in a supersaturated state at the bottom of the molten liquid reaches the low-temperature region of the upper portion of the molten liquid, supersaturated components are selectively crystallized easily. As a result of the base provided with the solid solution layer 4 having a structure similar to an oxide superconducting substance passing through this low-temperature region, crystal growth can be promoted based on the solid solution layer 4 having a structure similar to an oxide superconducting substance.

Furthermore, a molten liquid to which the composite metal elements of the oxide buffer layer 2 have not been added is required to be used for the molten liquid when performing the second round of liquid phase epitaxy. If the constituent metal elements of the oxide buffer layer 2 were to be added here, in the case of generating the oxide superconducting material layer, there would be a high risk of compounds containing constituent elements of the oxide buffer layer 2 precipitating together with the oxide superconducting material layer. Accordingly, constituent elements of the oxide superconductor for achieving the target composition should only be contained in the molten liquid used in this case.

By then heat treating the thick film oxide superconducting material layer obtained in this manner to a temperature of 350 to 600°C, and preferably in an oxygen atmosphere for several hours to several hundred hours, oxygen is adequately supplied to the oxide superconducting material layer and the crystal structure is aligned, thereby converting the oxide superconducting material layer to the oxide superconducting layer 5. As a result, an oxide superconducting conductor A can be obtained provided with the oxide superconducting layer 5 having satisfactory crystal orientation in the form of a thick film equivalent to that shown in FIG. 1. In addition, since constituent elements of the oxide buffer layer 2 other than constituent elements of an oxide superconductor are not contained in the molten liquid used for the second round of liquid phase epitaxy, the precipitation of unnecessary compound phases can be inhibited. Thereby, the precipitation of only an oxide superconducting material layer of the target composition is achieved and an oxide superconducting conductor having superior superconductivity can be obtained.

If the oxide superconducting layer 5 is formed by liquid phase epitaxy as explained above, a thick film oxide superconducting layer 5 having a thickness of about 2 x 10⁻⁶ m (2 µm) to 10 x 10⁻⁶ m (10 µm) can be obtained much faster than by a vapor phase method at a deposition rate of, for example, about 1 x 10⁻⁶ m (1 µm)/minute. CVD, which is known to have a comparatively fast deposition rate among vapor phase methods (such as sputtering, vapor deposition and CVD), has the ordinary deposition rate of about 0.01 x 10⁻⁶ m (0.01 µm)/minute. Therefore, it can be easily understood how fast the deposition rate is using liquid phase epitaxy.

Moreover, if the oxide superconducting seed layer 3 is formed with satisfactory crystal orientation on the oxide buffer layer 2, the orientation of the solid solution layer 4 having a structure similar to an oxide superconducting substance and formed by liquid phase epitaxy can also be made to be satisfactory. In addition, if the oxide superconducting layer 5 is obtained by liquid phase epitaxy based on this solid solution layer 4 having a structure similar to an oxide superconducting substance, it can also be obtained having satisfactory crystal orientation. Thereby, it is possible to provide an oxide superconducting conductor that exhibits superior critical current.

### Example 1

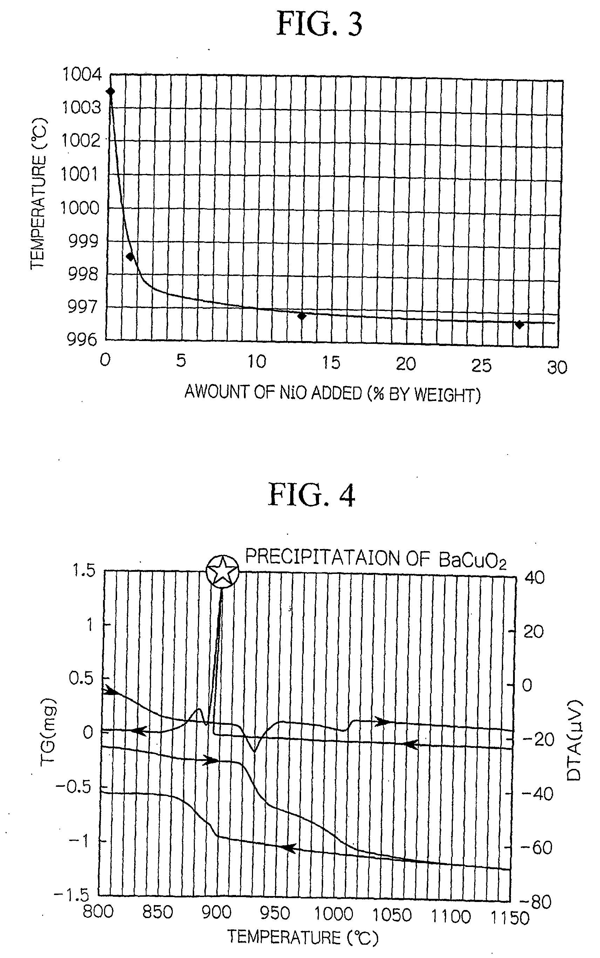

FIG. 2 shows the measurement results of thermal analysis of peritectic reaction temperature of an oxide superconductor having a composition represented with Y₁Ba₂Cu₃O_{y}. FIG. 3 is shows the change in peritectic reaction temperature in the case of adding predetermined amounts of NIO (0% by weight, 1.5% by weight, 13% by weight and 27.5% by weight). In the measurements, a molten liquid was used, which was obtained by mixing an oxide superconductor powder having a composition represented with Y₁Ba₂Cu₃O_{y}, a mixed powder in which the ratio of Ba:Cu was 3:5, and a NiO powder at the ratio of 1:1:1.5 and dissolving.

In FIG. 2, the DTA plotted on the vertical axis on the right side of the graph makes it possible to determine the temperature of the peritectic reaction from the results of thermal analysis, while TG plotted on the vertical axis on the left side of the graph indicates the change in weight, and both of these data serve as indicators for determining the peritectic reaction starting temperature.

In FIG. 2, the results are shown for measuring peritectic temperature in the case of having added 1.5% by weight of NiO. FIG. 3 determines the DTA results for NiO added amounts of 0% by weight, 1.5% by weight, 13% by weight and 27.5% by weight, respectively, and provides a plot of peritectic reaction temperature for each amount of NiO added. In the case of the sample of FIG. 2, the peritectic reaction temperature Tp exhibited a value of 998.5°C.

As is clear from the results of FIG. 3, peritectic reaction temperature can be seen to decrease suddenly when minute amounts of NiO are added. For example, based on the relationship shown in FIG. 3, peritectic temperature was able to lowered by about 5°C when only 1.5% by weight of NiO was added, and was able to be lowered by about 6 to 7°C when NiO was added within the range of 4% by weight to 30% by weight.

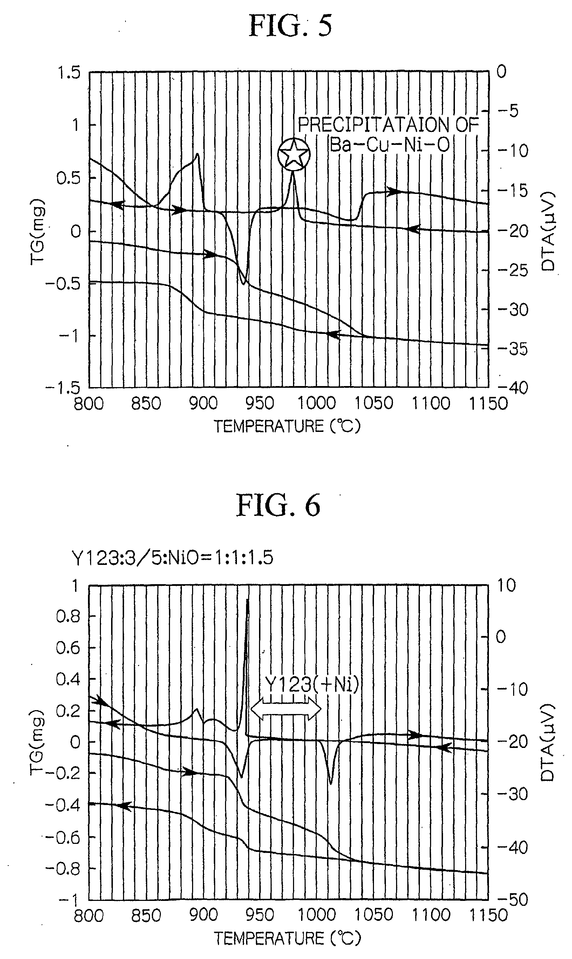

FIG. 4 shows the crystallization temperature of a BaCuO₂ in the case of performing liquid phase epitaxy using a molten liquid containing Ba and Cu at the ratio of 3:5. FIG. 5 shows the crystallization temperature of a Ba-Cu-Ni-O compound in the case of adding 10% by weight of NiO to a molten liquid containing Ba and Cu at a ratio of 3:5.

FIG. 6 shows the results of measuring the DTA of a molten liquid which was obtained by mixing a mixed powder containing Ba and Cu at a ratio of 3:5 (abbreviated as 3/5 powder), an oxide superconductor powder represented with the compositional formula Y₁Ba₂Cu₃O_{y} (abbreviated as Y123 powder) and a NiO powder at the ratio of Y123 powder: 3/5 powder: NiO powder = 1:1:1.5.

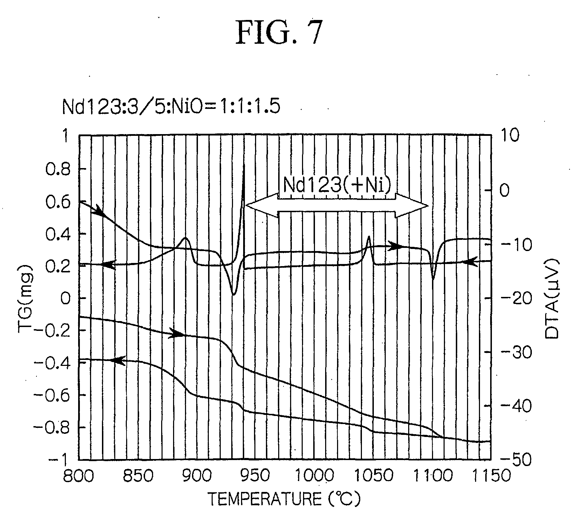

FIG. 7 shows the results of measuring the DTA of a molten liquid which was obtained by mixing a mixed powder containing Ba and Cu at a ratio of 3:5 (abbreviated as 3/5 powder), an oxide superconductor powder represented with the compositional formula Nd₁Ba₂Cu₃O_{y} (abbreviated as Nd123 powder), and a NiO powder at the ratio of Nd123 powder : 3/5 powder : NiO powder = 1:1:1.5.

As shown in FIG. 6, in the case of using the molten liquid in which NiO powder was added to a molten liquid containing Y123 powder, the downward peak of an endothermic reaction that can be interpreted to be the peritectic temperature of Y₁Ba₂Cu₃O_{y} is about 1,010°C, while the temperature of the sharp upward peak that is the temperature observed when the other compound phase precipitates is about 940°C, and the temperature difference between the two being about 70°C. In contrast, as shown in FIG. 7, the same temperature difference in the case of a molten liquid containing Nd123 powder is about 160°C. The temperature margin is larger in the case of Nd123.

This indicates that, in the case of carrying out precipitation by liquid phase epitaxy, a molten liquid containing Nd123 powder makes it more difficult for the unnecessary compound phase to precipitate, while precipitation by liquid phase epitaxy is easier for Nd123.

On the basis of these, in the case of performing liquid phase epitaxy using a molten liquid to which NiO has been added, it is clear that rather than precipitation using the molten liquid of Y123, precipitation using the molten liquid of Nd123 allows a superconducting layer to precipitate more reliably without precipitation of an unnecessary compound phase.

Based on this finding, liquid phase epitaxy was performed below using a molten liquid in which NiO was added to a molten liquid of Nd123.

A crucible was heated so that the bottom portion of the crucible was about 1,080°C and the upper portion of the crucible was at 1,057°C, and a molten liquid having a composition of Nd₄Ba₂Cu₂O_{y} was present in the bottom portion of the crucible, while a molten liquid having a composition of NiO + Ba₃Cu₄Oₓ was present in the upper portion of the crucible. Molten liquid heated to this temperature had a bi-layer structure in which the molten liquid of the upper portion had a composition of NiO + Ba₃Cu₄Oₓ and molten liquid having a composition of Nd₄Ba₂Cu₂Oₓ was present in the bottom portion.

On the other hand, a NiO oxide buffer layer having a thickness of 1 x 10⁻⁶ m (1 µm) and oriented within the (100) plane was formed on a Ni oriented substrate (base material) having 0.2 mm thick, 10 mm wide and 500 mm long and the surface of which had been self-oxidized. After that, an oxide superconducting seed layer represented with the compositional formula Y₁Ba₂Cu₃O_{y} and having thickness of 200 nm oriented within the (100) plane was formed on the upper surface of the NiO oxide buffer layer by laser deposition. A solid solution layer having a structure similar to an oxide superconducting substance and a thickness of 5 x 10⁻⁶ m (5 µm) was then formed on the oxide superconducting seed layer by liquid phase epitaxy using the previously prepared NdBCuO molten liquid saturated with NiO.

Next, an oxide superconducting material layer having a thickness of 10 x 10⁻⁶ m (10 µm) was formed by liquid phase epitaxy using a molten liquid of YBCuO to which NiO had not been added. Next, this oxide superconducting material layer was subjected to heat treatment by heating for 72 hours at 500°C in an oxygen atmosphere to generate an oxide superconducting layer and obtain an oxide superconducting conductor.

When the electrical continuity of this oxide superconducting conductor was tested according to the four probe method in a null magnetic field in liquid nitrogen, critical current (Ic) of 200 A was able to be obtained, thereby confirming this oxide superconducting conductor to be a superior superconducting conductor.

### Example 2

An orientated Ni base alloy base material was heated for 30 minutes at 1,100°C in an Ar atmosphere, and it was self-oxidized, and thereby a NiO buffer layer to serve as an oxide buffer layer was formed on the surface of the base material. Next, a biaxially oriented oxide superconducting seed film represented with the compositional formula Sm₁Ba₂Cu₃O_{y} (abbreviated as Sm123) was deposited by laser deposition on this NiO buffer layer.

Next, in order to form a solid solution layer by a first round of liquid phase epitaxy, Sm₂BaCu₅ powder was sprinkled on the bottom of a Sm₂O₃ crucible and powder having a composition of Ba₃Cu₅O₈ to serve as a solvent was placed over it followed by heating in an electric furnace and raising the temperature to about 1,100°C to dissolve. After dissolving, NiO powder was added to the solution until it was saturated. Next, in order to carry out growth of Ni-substituted Sm123 from this Ni saturated solution (Ni saturated molten liquid), the liquid surface temperature was held at about 1,040°C and the liquid bottom temperature was held at about 1,060°C, and the oriented Ni alloy base material, on which was formed the NiO buffer layer and the oxide superconducting seed film, was immersed in this Ni saturated molten liquid to deposit a Ni-saturated Sm123 layer while inhibiting reaction between the substrate and molten liquid and obtain a Sm123-Ni layer (solid solution layer) having a thickness of about 5 µm.

Next, in order to deposit an oxide superconducting layer that demonstrates superconducting characteristics by a second round of liquid phase epitaxy, Y₂BaCuO₅ powder was placed in a Y₂O₃ crucible, powder having a composition of Ba₃Cu₇O₁₀ serving as solvent was placed over it, and then dissolved by heating to about 1,030°C with an electric furnace. The liquid surface temperature of this Y-Ba-Cu-O solution was held at about 970°C and the liquid bottom temperature was held at about 980°C followed by immersion of the base material deposited to the Sm123-Ni layer (solid solution layer) to form a Y₁Ba₂Cu₃O_{y} layer (Y123 layer) having a thickness of about 10 µm.

Next, the base material on which this Y₁Ba₂Cu₃O_{y} layer was formed was subjected to oxygen-fed heat treatment at about 500°C in the presence of flowing oxygen. Then, when its electrical characteristics were measured, a value of 91K was obtained for the critical temperature (Tc). In addition, a value of 3 x 10⁵ A/cm² was obtained for the critical current density (Jc), thereby confirming this to be a superior superconducting conductor.

## Claims

1. An oxide superconducting conductor comprising:
an oxide buffer layer on a base material composed of a high melting point metal;
a solid solution layer having a structure similar to an oxide superconducting substance containing constituent elements of the oxide buffer layer on the oxide buffer layer; and
an oxide superconducting layer having a peritectic temperature lower than that of the solid solution layer on the solid solution layer having a structure similar to an oxide superconducting substance.

2. An oxide superconducting conductor comprising:
an oxide buffer layer composed of NiO on a base material composed of a high melting point metal;
a solid solution layer having a structure similar to an oxide superconducting substance containing NiO on the oxide buffer layer; and
an oxide superconducting layer having a peritectic temperature lower than that of the solid solution layer on the solid solution layer having a structure similar to an oxide superconducting substance.

3. An oxide superconducting conductor comprising:
an oxide buffer layer on a base material composed of a high melting point metal;
an Nd-based solid solution layer having a structure similar to an oxide superconducting substance containing constituent elements of the oxide buffer layer on the oxide buffer layer; and
an oxide superconducting layer composed of a Sm-, Gd-, Dy-, Y- or Yb-based oxide superconductor having a peritectic temperature lower than that of an Nd-based oxide superconductor that composes the Nd-based solid solution layer on the Nd-based solid solution layer having a structure similar to an oxide superconducting substance.

4. An oxide superconducting conductor comprising:
an oxide buffer layer composed of NiO on a base material composed of a high melting point metal;
an Nd-based solid solution layer having a structure similar to an oxide superconducting substance containing NiO on the oxide buffer layer; and
an oxide superconducting layer composed of a Sm-, Gd-, Dy-, Y- or Yb-based oxide superconductor having a peritectic temperature lower than that of an Nd-based oxide superconductor that composes the Nd-based solid solution layer on the Nd-based solid solution layer having a structure similar to an oxide superconducting substance.

5. An oxide superconducting conductor comprising:
an oxide buffer layer composed of NiO on a base material composed of a Ni-based alloy;
a Nd-based solid solution layer having a structure similar to an oxide superconducting substance containing NiO on the oxide buffer layer; and
an oxide superconducting layer composed of a Y-based oxide superconductor having a peritectic temperature lower than that of an Nd-based oxide superconductor that composes the Nd-based solid solution layer on the Nd-based solid solution layer having a structure similar to an oxide superconducting substance.

6. An oxide superconducting conductor comprising:
an oxide buffer layer on a base material composed of a high melting point metal;
a Sm-based solid solution layer having a structure similar to an oxide superconducting substance containing constituent elements of the oxide buffer layer on the oxide buffer layer; and
an oxide superconductor layer composed of a Gd-, Dy-, Y- or Yb-based oxide superconductor having a peritectic temperature lower than that of a Sm-based oxide superconductor that composes the Sm-based solid solution layer on the Sm-based solid solution layer having a structure similar to an oxide superconducting substance.

7. An oxide superconducting conductor comprising:
an oxide buffer layer composed of NiO on a base material composed of a high melting point metal;
a Sm-based solid solution layer having a structure similar to an oxide superconducting substance containing NiO on the oxide buffer layer; and
an oxide superconducting layer composed of a Gd-, Dy-, Y- or Yb-based oxide superconductor having a peritectic temperature lower than that of a Sm-based oxide superconductor that composes the Sm-based solid solution layer on the Sm-based solid solution layer having a structure similar to an oxide superconducting substance.

8. An oxide superconducting conductor comprising:
an oxide buffer layer composed of NiO on a base material composed of a Ni-based alloy;
a Sm-based solid solution layer having a structure similar to an oxide superconducting substance containing NiO on the oxide buffer layer; and
an oxide superconducting layer composed of a Y-based oxide superconductor having a peritectic temperature lower than that of a Sm-based oxide superconductor that composes the Sm-based solid solution layer on the Sm-based solution layer having a structure similar to an oxide superconducting substance.

9. An oxide superconducting conductor according to claim 1, wherein the solid solution layer having a structure similar to an oxide superconducting substance is formed by liquid phase epitaxy in which the base material is immersed in a molten liquid, and the oxide superconducting layer is formed by liquid phase epitaxy in which the base material is immersed in a molten liquid.

10. An oxide superconducting conductor according to claim 2, wherein the solid solution layer having a structure similar to an oxide superconducting substance is formed by liquid phase epitaxy in which the base material is immersed in a molten liquid, and the oxide superconducting layer is formed by liquid phase epitaxy in which the base material is immersed in a molten liquid.

11. A production method of an oxide superconducting conductor according to claim 1 comprising the steps of:
dissolving metal elements that compose an oxide buffer layer in a molten liquid of elements that compose a solid solution layer;
immersing a base material provided with an oxide buffer layer in the obtained molten liquid and removing the base material provided with an oxide buffer layer from the obtained molten liquid, and thereby forming a solid solution layer having a structure similar to an oxide superconducting substance on the oxide buffer layer while preventing dissolution of the oxide buffer layer itself; and
forming an oxide superconducting layer on the solid solution layer having a structure similar to an oxide superconducting substance.

12. A production method of an oxide superconducting conductor according to claim 11, wherein when forming the oxide superconducting layer on the solid solution layer having a structure similar to an oxide superconducting substance, liquid phase epitaxy is carried out for generating an oxide superconducting layer while preventing dissolution of the solid solution layer by immersing the base material provided with the solid solution layer in a molten liquid that does not contain metal elements that compose the oxide buffer layer but contains elements that compose the oxide superconducting layer.

13. A production method of an oxide superconducting conductor according to claim 11, wherein a base material composed of a Ni-based alloy is used for the base material, and an oxide buffer layer composed of Ni oxide is used for the oxide buffer layer.

14. A production method of an oxide superconducting conductor according to claim 12, wherein a base material composed of Ni-based alloy is used for the base material, and an oxide buffer layer composed of Ni oxide is used for the oxide buffer layer.
